# EUROPEAN PATENT SPECIFICATION

(11) **EP 0 320 971 B1**
(45) Date of publication and mention of the grant of the patent: **27.07.1994**
(21) Application number: 88121114.8
(22) Date of filing: 16.12.1988
(51) Int. Cl.: C30B 25/02, C30B 25/10, C23C 16/46

(54) **Epitaxial growth apparatus**
Vorrichtung für epitaxiales Aufwachsen
Dispositif pour la croissance épitaxiale

(30) Priority: 18.12.1987 JP 320427/87
(43) Date of publication of application: 21.06.1989
(73) Proprietor: KABUSHIKI KAISHA TOSHIBA, Kawasaki-shi, Kanagawa-ken 210 (JP)
(72) Inventor: Saito, Yoshihiko, Minato-ku Tokyo 105 (JP); Matsushita, Yoshiaki, Minato-ku Tokyo 105 (JP)
(74) Representative: Henkel, Feiler, Hänzel & Partner

(56) References cited:
- EP-A- 0 107 344
- EP-A- 0 252 667
- PATENT ABSTRACTS OF JAPAN, vol. 9, no. 328 (E-369), December 24, 1985; & JP-A-60 161 616
- PATENT ABSTRACTS OF JAPAN, vol. 9, no. 189 (E-333), August 06, 1985; & JP-A-60 058 613
- PATENT ABSTRACTS OF JAPAN, vol. 10, no. 1 (E-371), January 1986; & JP-A-60 165 714
- PATENT ABSTRACTS OF JAPAN, vol. 8, no. 281 (E-286)(1718), December 21, 1984; & JP-A-59 149 020

## Description

The present invention relates to an epitaxial growth apparatus for forming an epitaxial growth layer on a semiconductor wafer such as a VLSI silicon wafer.

In recent years, VLSIs (very large scale integrated circuits) have been developed. Along with this, an application of a wafer on which silicon is epitaxially grown (i.e., an epitaxial wafer) into VLSIs has been taken into consideration.

Excellent crystallinity is the most important factor of wafers used for VLSI fabrication. If such a wafer is an epitaxial wafer, several problems posed by the epitaxial process must also be solved. First, fine particles such as silicon dust are attached to mirror surfaces of wafers during the epitaxial process. These fine particles are formed such that, for example, silicon deposited in a reaction furnace is peeled. When such fine particles are attached to the mirror surfaces of wafers, mounds and/or spikes are formed on the mirror surfaces to prevent epitaxial growth. Second, lattice defects (slips) are formed during heating/cooling in the epitaxial process. More slips are formed when a wafer diameter is increased.

Reaction furnaces for epitaxial growth apparatuses are classified into vertical, cylindrical, and lateral furnaces. Wafer heating systems for epitaxial growth apparatuses are classified into RF induction heating, infrared heating, and resistive heating. Reaction furnaces currently used in fabrication of wafers are vertical and cylindrical furnaces. RF induction heating is mainly employed in the vertical furnace. Infrared heating is mainly employed in the cylindrical furnace.

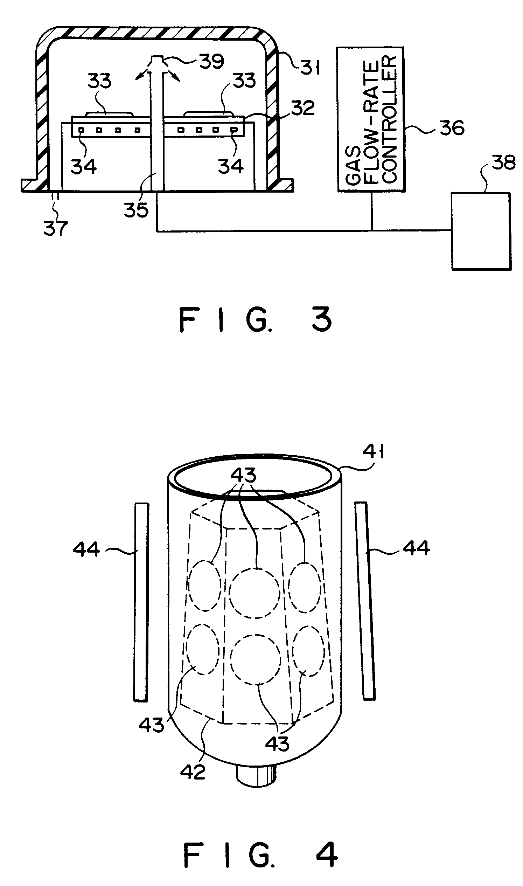

A sectional structure of a conventional vertical furnace employing RF induction heating is shown in Fig. 3. This vertical furnace includes quartz bell jar 31. Susceptor 32 is horizontally arranged in bell jar 31. Wafers 33 are placed on susceptor 32 such that mirror surfaces face up. Wafers 33 placed on susceptor 32 are heated by RF induction heating using heating coil 34. Gas pipe 35 is disposed at the center in bell jar 31. A reaction gas supplied from gas tank 38 arranged outside bell jar 31 passes through gas pipe 35 and is supplied from gas inlet 39 formed at the upper portion of gas pipe 35 to the interior to bell jar 31. Gas flow-rate controller 36 controls a flow rate or the like of the reaction gas supplied to bell jar 31. Gas outlet 37 is formed at the bottom portion of bell jar 31.

A conventional cylindrical furnace employing infrared heating is shown in Fig. 4. This cylindrical furnace includes quartz cylinder 41. Pyramidal susceptor 42 having a plurality of flat surfaces is arranged inside cylinder 41. Wafers 43 lean against the respective surfaces of susceptor 42. As a result, wafers 43 are vertically oriented. Infrared lamps 44 are arranged outside cylinder 41. Infrared rays emitted from infrared lamps 44 are emitted on wafers 43 through cylinder 41, thereby heating wafers 43.

When RF induction heating is employed as in the vertical furnace shown in Fig. 3, a slip tends to occur on an epitaxial layer grown on each wafer. In particular, this tendency becomes typical when the wafer diameter is increased.

The slip formed on the epitaxial layer can be suppressed by changing a wafer heating system into infrared heating or the like. Simultaneous use of RF induction heating and infrared heating is taken into consideration due to the above reason. However, even when an additional heating system is employed, it is difficult to prevent a slip formed on the epitaxial growth layer on, e.g., a 6' or 8' wafer.

In the vertical furnace shown in Fig. 3, wafers are placed on the susceptor such that mirror surfaces face up. Such a vertical furnace has a disadvantage in that silicon dust and the like present in the furnace tends to be attached to mirror surfaces of wafers and mounds and/or spikes tend to be formed thereon.

To the contrary, in the cylindrical furnace shown in Fig. 4, since infrared heating is employed as a wafer heating system, formation of a slip on the epitaxial layer can be reduced. However, it is very difficult to control a film thickness profile of the epitaxial layer in the cylindrical furnace as compared with the vertical furnace. In addition, the cylindrical furnace has the following drawback.

In general, in the process for growing an epitaxial layer on a wafer, a reaction temperature must be low, as is known to those skilled in the art. A low reaction temperature provides a slip-free wafer and allows precise control of an impurity profile. In order to reduce a reaction temperature, a very active gas which allows epitaxial growth at low temperatures must be used. However, when a very active reaction gas is used in the cylindrical furnace (Fig. 4) employing infrared heating, silicon is undesirably deposited on the inner wall surface (wall deposition) of cylinder 41. Cylinder 41 having an inner wall surface on which silicon is deposited shields infrared rays emitted from infrared lamps arranged outside the cylinder, and an intensity of infrared rays which reach the wafers is reduced. As a result, wafer temperatures are lowered, and growth of epitaxial layers is finally stopped. Therefore, a low reaction temperature cannot be used in a conventional reaction furnace employing infrared heating.

Prior art document Patent Abstracts of Japan vol. 10, no. 1 (E-371), 7 January 1986 (JP-A-60 165 714) describes a vapor growth method and apparatus thereof in which a carbon is provided in separation downward from a holder and heated by high frequency so that a substrate is kept at a temperature of 800 - 1000°C. In this apparatus carbon is used as a radiation source, so that, if silicon is deposited on the radiation source, it is impossible to maintain a uniform intensity of the radiation over the entire region.

Further, prior art document Patent Abstracts of Japan vol. 8, no. 281 (E-286)(1718), 21 December 1984 (JP-A-59 149 020) discloses a vertical type reaction furnace having a susceptor consisting of silicone carbide on which a silicon wafer is directly placed. A disc-shaped cover, consisting of stainless steel, silicon carbide, quartz and the like is installed on a bell jar through the intermediary of a fixture. The cover is provided above the susceptor in parallel with each other, and a heater is built in the cover.

It is an object of the present invention to provide an epitaxial growth apparatus which allows the formation of an epitaxial layer substantially free from defects at a low temperature.

To solve this object, the present invention provides an epitaxial growth apparatus as specified in claim 1.

The epitaxial growth apparatus of the present invention is suitably used for epitaxially growing silicon on a semiconductor wafer such as a silicon wafer by using a very active reaction gas such as silane (SiH₄) gas or disilane (Si₂H₆) gas.

This invention can be more fully understood from the following detailed description when taken in conjunction with the accompanying drawings, in which:
Fig. 1 is a schematic sectional view of an epitaxial growth apparatus according to an embodiment of the present invention;
Fig. 2 is a sectional view showing a wafer holder of the epitaxial growth apparatus shown in Fig. 1;
Fig. 3 is a sectional view of a conventional vertical furnace; and
Fig. 4 is a perspective view of a conventional cylindrical furnace.

An epitaxial growth apparatus according to the present invention will be described with reference to the accompanying drawings.

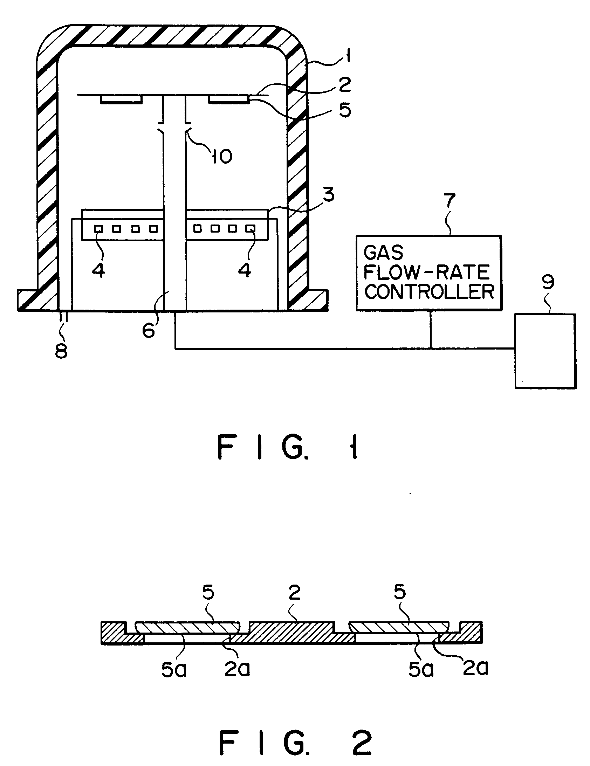

The epitaxial growth apparatus according to the present invention, as shown in Fig. 1, includes quartz bell jar 1. Susceptor 2 and infrared ray radiation source 3 are arranged inside bell jar 1. Susceptor 2 holds wafers 5. Infrared ray radiation source 3 heats wafers 5 held by susceptor 2. Infrared ray radiation source 3 is disposed spaced apart from wafers 5 held on susceptor 2 and is not brought into contact with wafers 5. In addition, infrared ray radiation source 3 is located at a position where infrared rays emitted therefrom are not shielded but can reach wafers 5 directly. Infrared ray radiation source 3 is heated by heating coil 4 to emit infrared rays. Gas pipe 6 is located at the central portion in bell jar 1. The lower end of gas pipe 6 is connected to gas tank 9 which is located outside bell jar 1 and serves as a reaction gas source. A reaction gas flowing out from gas tank 9 is supplied from gas inlet 10 formed at the upper portion of gas pipe 6 to bell jar 1 through gas pipe 6. A flow rate or the like of the reaction gas supplied to bell jar 1 is controlled by gas flow-rate controller 7.

An example of a material of susceptor 2 is high-purity quartz, a material obtained by coating high-purity quartz with silicon carbide (SiC), or a material obtained by coating carbon graphite with SiC.

Fig. 2 is a sectional view showing susceptor 2. Through holes 2a having a diameter slightly smaller than that of wafer 5 are formed in susceptor 2. Susceptor portions around the holes are stepped portions, respectively. Each wafer 5 is placed on susceptor 2 at the stepped portion such that its mirror surface 5a is exposed through holes 2a. When wafers 5 are held by susceptor 2 in the above state, mirror surfaces 5a of wafers 5 face down in the reaction furnace. Since the mirror surfaces of the wafers face down, an attachment rate of fine particles such as silicon dust which causes mounds and/or spikes on the mirror surfaces of wafers can be reduced. In addition, susceptor 2 is preferably rotated by a rotating mechanism.

A material for causing epitaxial growth on a wafer is deposited on the surface of infrared ray radiation source 3 when the epitaxial process is progressed. That is, when silicon is epitaxially grown on each wafer, silicon is also deposited on the surface of infrared ray radiation source 3. In this case, when a crack is formed in a silicon layer deposited on the surface of infrared ray radiation source 3, an intensity of infrared rays emitted from radiation source 3 varies depending on emission portions. In particular, when infrared rays emitted from the infrared ray radiation source have a nonuniform intensity distribution, epitaxial growth on wafers is adversely affected. Therefore, a material for infrared ray radiation source 3 must be selected such that even if an epitaxial growth material is deposited on the surface of radiation source 3, the intensity of infrared rays can be kept constant throughout the entire surface. For example, if an epitaxial growth material is silicon, the material for infrared ray radiation source 3 can be carbon graphite, or a material obtained by coating carbon graphite with SiC.

Infrared ray radiation source 3 is heated by heating means 4 to emit infrared rays. In the epitaxial growth apparatus shown in Fig. 1, a means for heating infrared ray radiation source 3 is heating coil 4. However, the means for heating the infrared ray radiation source is not limited to a heating coil. If an intensity of infrared rays emitted from the heated infrared ray radiation source is sufficient to heat wafers 5 to a predetermined temperature, any heating means can be employed. For example, heating can be performed by resistive heating or electromagnetic heating.

Gas inlet 10 may be formed at any position of gas pipe 6. However, the position of gas inlet 10 is preferably slightly lower than the position of susceptor 2.

In the epitaxial growth apparatus shown in Fig. 1, infrared ray radiation source 3 is arranged at a position away from wafers 5 and infrared rays are used as a heating means for wafers. The slip tends not to be formed on the epitaxial layer as compared with heating of wafers by RF induction heating. Even if a slip condition of an epitaxial layer in the conventional vertical furnace (Fig. 3) is given, it is confirmed that a slip-free condition of an epitaxial layer can be set in the epitaxial growth apparatus of this embodiment.

In the epitaxial growth apparatus shown in Fig. 1, infrared ray radiation source 3 for heating wafers is arranged inside bell jar 1. In addition, infrared ray radiation source 3 consists of a material which provides a uniform intensity throughout the entire surface even if silicon is deposited on the surface. For these reasons, even if wall deposition and deposition of silicon on the surface of the infrared ray radiation source occurs, a good epitaxial layer can be grown. Therefore, in the epitaxial growth apparatus of this embodiment, a very active reaction gas such as silane, disilane, or dichlorosilane which allows low-temperature epitaxial growth can be used. Even if epitaxial growth was actually performed at low temperatures of 900°C or less, slip-free epitaxial layers could be grown on 6' and 8' wafers.

In the epitaxial growth apparatus shown in Fig. 1, the mirror surfaces of the wafers face down. Attachment of fine particles or the like to the mirror surfaces can be prevented, and hence formation of mounds and/or spikes can be prevented. When disilane gas was used as a reaction gas, the number of mounds and spikes formed on the mirror surface was 10³/per wafer at maximum in the conventional vertical furnace in which the wafer mirror surfaces face up. However, the number of mounds and spikes formed on the mirror surface was 10 or less per wafer in the epitaxial growth apparatus of this embodiment. Therefore, when the epitaxial growth apparatus of this embodiment is employed, the number of mounds and/or spikes formed on the mirror surface of the wafer can be greatly reduced.

The epitaxial growth apparatus according to the present invention is not limited to an application for a vertical furnace but is applicable to other types of reaction furnace.

## Claims

1. An apparatus for epitaxially growing silicon comprising:
- a reaction vessel (1);
- holding means (2), arranged inside said reaction vessel (1), for holding at least one semiconductor wafer (5) subjected to epitaxial growth;
- an infrared ray radiation source (3) arranged inside said reaction vessel (1) and spaced apart from the semiconductor wafers (5) held on said holding means (2), the source (3) being located at a position where infrared rays can directly reach and heat the semiconductor wafers (5);
- gas inlet means (10), for supplying a reaction gas into said reaction vessel (1); and
- gas outlet means (8), for exhausting a waste gas from said reaction vessel (1),
characterized in that
- said infrared ray radiation source (3) consists of carbon graphite or a material obtained by coating carbon graphite with silicon carbide.

2. An apparatus according to claim 1, characterized in that the semi-conductor wafer is a silicon wafer.

3. An apparatus according to claim 1, characterized in that said holding means (2) holds the semiconductor wafer (5) such that a mirror surface thereof face down.

## Patentansprüche

1. Vorrichtung für epitaxiales Aufwachsen bzw. Züchten von Silizium mit:
- einem Reaktionsgefäß (1);
- einer Halteeinrichtung (2), die in dem Reaktionsgefäß (1) angeordnet ist,
zum Halten von mindestens einer Halbleiterscheibe (5), die epitaxialem Aufwachsen unterliegt:
- einer Infrarotstrahl-Strahlungsquelle (3), die in dem Reaktionsgefäß (1) angeordnet und von den Halbleiterscheiben (5), die auf der Halteeinrichtung (2) gehalten sind, beabstandet ist, wobei sich die Quelle (3) an einer Position befindet, an der Infrarotstrahlen die Halbleiterscheiben (5) direkt erreichen und erwärmen können:
- einer Gaseinlaßeinrichtung (10) zum Liefern eines Reaktionsgases in das Reaktionsgefäß (1); und
- einer Gasauslaßeinrichtung (8) zum Absaugen bzw. Ablassen eines Abgases aus dem Reaktionsgefäß (1);
dadurch gekennzeichnet, daß
die Infrarotstrahl-Strahlungsquelle (3) aus Kohlegraphit oder einem Material. das durch Beschichten von Kohlegraphit mit Siliziumkarbid erhalten ist, besteht.

2. Vorrichtung nach Anspruch 1, dadurch gekennzeichnet, daß die Halbleiterscheibe eine Siliziumscheibe ist.

3. Vorrichtung nach Anspruch 1, dadurch gekennzeichnet, daß die Halteeinrichtung (2) die Halbleiterscheibe (5) so hält, daß eine Spiegeloberfläche davon nach unten gerichtet ist.

## Revendications

1. Appareil pour la croissance épitaxiale de silicium, comprenant :
- une enceinte de réaction (1) ;
- des moyens de support (2), agencés à l'intérieur de ladite enceinte de réaction (1) afin de supporter au moins une plaquette semi-conductrice (5) soumise à une croissance épitaxiale ;
- une source de rayonnement à infrarouge (3) agencée à l'intérieur de ladite enceinte de réaction (1) et écartée des plaquettes semi-conductrices (5) maintenues sur lesdits moyens de support (2), la source (3) étant placée à une position où des rayons infrarouges peuvent atteindre directement et chauffer les plaquettes semi-conductrices (5) ;
- des moyens d'entrée de gaz (10) pour alimenter un gaz de réaction dans ladite enceinte de réaction (1) ; et
- des moyens de sortie de gaz (8) pour évacuer un gaz d'échappement hors de ladite enceinte de réaction (1),
caractérisé en ce que
- ladite source de rayonnement à infrarouge (3) est constituée de graphite ou d'un matériau obtenu en revêtant du graphite avec du carbure de silicium.

2. Appareil selon la revendication 1, caractérisé en ce que la plaquette semi-conductrice est une plaquette de silicium.

3. Appareil selon la revendication 1, caractérisé en ce que lesdits moyens de support (2) supportent la plaquette semi-conductrice (5) de telle manière qu'une surface polie de celle-ci est dirigée vers le bas.
